# EUROPEAN PATENT APPLICATION

(11) **EP 4 624 904 A2**
(43) Date of publication of application: **01.10.2025**
(21) Application number: 25165996.7
(22) Date of filing: 25.03.2025
(51) Int. Cl.: G01N 21/64, G01N 21/95, H01L 21/02

(54) **INSPECTING METHOD AND STACK SUBSTRATE**

(30) Priority: 29.03.2024 JP 2024055256; 24.06.2024 JP 2024101201; 24.06.2024 JP 2024101065
(71) Applicant: Proterial, Ltd., Tokyo 135-0061 (JP)
(72) Inventor: MIURA, Tsuyoshi, Tokyo, 1350061 (JP); HIROOKA, Taisuke, Tokyo, 1350061 (JP); OKUDA, Hiroyuki, Tokyo, 1350061 (JP)
(74) Representative: Wilson Gunn

(57) **Abstract**

An inspection method of detecting "BPD" in a buffer layer is established. An inspecting method is an inspecting method of detecting a crystal defect in a buffer layer by using a first image based on a reflected light caused by irradiation with a light on the buffer layer and a second image based on a photoluminescence light caused by irradiation with an excitation light on the buffer layer. The buffer layer is made of silicon carbide into which a conductive impurity is introduced. A wavelength of the excitation light is equal to or less than 386 nm**.** A cumulative irradiance of the excitation light is equal to or more than 1.6 W·cm⁻²·sec. The photoluminescence light is received through a light receiving filter. The light receiving filter is a filter transmitting light having a wavelength being equal to or more than the wavelength of the excitation light and equal to or less than 399 nm.

## Description

### CROSS-REFERENCE TO RELATED APPLICATION

The present application claims priority from Japanese Patent Applications No. 2024-055256 filed on March 29, 2024, No. 2024-101201 filed on June 24, 2024, and No. 2024-101065 filed on June 24, 2024, the content of which is hereby incorporated by reference into this application.

### TECHNICAL FIELD OF THE INVENTION

The present invention relates to an inspecting method and a stack substrate, and relates to, for example, a technique effectively applied to an inspecting method of detecting a crystal defect in a buffer layer formed on a silicon carbide substrate and a stack substrate including the buffer layer formed on the silicon carbide substrate.

### BACKGROUND OF THE INVENTION

Japanese Patent Application Laid-open Publication No. 2015-119056 (Patent Document 1) describes an inspecting method of detecting a crystal defect in an epitaxial layer by using a first image based on a reflected light caused by irradiation with a light on the epitaxial layer and a second image based on a photoluminescence light caused by irradiation with an excitation light on the epitaxial layer.

Japanese Patent No. 7368041 (Patent Document 2) describes a method of detecting a candidate region forming a defect image of "Shockley-Type Stacking Fault (may be called SSF below)" as a region including "basal plane dislocation (may be called BPD below)" by irradiation with a high-irradiance ultraviolet ray on an entire stack substrate including a silicon carbide substrate, a buffer layer formed on the silicon carbide substrate, and a drift layer formed on the buffer layer to extend the "SSF" to the "BPD" in the drift layer, the "BPD" in the buffer layer, and the "BPD" converted into "threading edge dislocation (may be called TED below)" at the interface between the buffer layer and the silicon carbide substrate.

"Status of development of low resistivity SiC single crystals for power device applications," Journal of the Japanese Association for Crystal Growth, Vol. 45, No. 3 (2018) 45-3-01 (Non-Patent Document 1) describes bipolar degradation.

### SUMMARY OF THE INVENTION

For example, in power devices using silicon carbide, it is desirable to suppress degradation in forward current to improve long-term reliability. For this, it is important to reduce the "BPD" as a cause of the degradation in forward current. Particularly, it is important to reduce the "BPD" in not only the drift layer but also the buffer layer.

In this regard, a technique of detecting the "BPD" in the buffer layer has not been established yet. Thus, the technique of detecting the "BPD" in the buffer layer has been awaited in order to achieve the power devices where the degradation in forward current can be suppressed to improve the long-term reliability.

An inspecting method according to one embodiment is an inspecting method of detecting a crystal defect in a buffer layer by using a first image based on a reflected light caused by irradiation with a light on the buffer layer and a second image based on a photoluminescence light caused by irradiation with an excitation light on the buffer layer. The buffer layer is made of silicon carbide into which a conductive impurity is introduced. A wavelength of the excitation light is equal to or less than 386 nm. A cumulative irradiance of the excitation light is equal to or more than 1.6 W·cm⁻²·sec. The photoluminescence light is received through a light receiving filter. A wavelength of the received light is equal to or more than the wavelength of the excitation light and equal to or less than 399 nm.

A stack substrate according to one embodiment includes a silicon carbide substrate, a buffer layer formed on the silicon carbide substrate, and a drift layer formed on the buffer layer. A basal plane dislocation density in the buffer layer is equal to or more than 0 cm⁻² and less than 5 cm⁻².

A stack substrate according to one embodiment includes a silicon carbide substrate having a first dopant concentration, a low-concentration buffer layer formed on the silicon carbide substrate and having a second dopant concentration lower than the first dopant concentration, a high-concentration buffer layer formed on the low-concentration buffer layer and having a third dopant concentration higher than the second dopant concentration and lower than the first dopant concentration, and a drift layer formed on the high-concentration buffer layer and having a fourth dopant concentration lower than the third dopant concentration.

According to one embodiment, a detecting method of detecting "BPD" in a buffer layer can be established. Consequently, according to one embodiment, the "BPD" in the buffer layer can be reduced.

### BRIEF DESCRIPTIONS OF THE DRAWINGS

FIG. 1 is a photograph showing that "BPD" is detected as a linear black defect in a photoluminescence image of an NUV filter;
FIG. 2A is a photograph showing a photoluminescence image of the NUV filter;
FIG. 2B is a photograph showing a surface image provided after KOH etching;
FIG. 3 is a diagram illustrating a configuration of a stack substrate;
FIG. 4 is a flowchart illustrating a flow of manufacturing steps for manufacturing a product substrate having a low "BPD" density in a buffer layer;
FIG. 5 is a diagram illustrating a configuration of a stack substrate in a "double layer buffer configuration"; and
FIG. 6 is a graph illustrating results of evaluating a "BPD" density in a high-concentration buffer layers.

### DESCRIPTIONS OF THE PREFERRED EMBODIMENTS

The same components are denoted by the same reference symbols throughout all the drawings for describing the embodiments, and the repetitive description thereof will be omitted. Note that even a plan view may be hatched so as to make the drawing easy to see.

### <Wide-Bandgap Semiconductor Material>

For example, an inverter circuit is used as a circuit for controlling a motor included in an automobile or a home electric appliance. As the inverter circuit, a power semiconductor element such as a metal oxide semiconductor field effect transistor (MOSFET) or an insulated gate bipolar transistor (IGBT) is used.

Such a power semiconductor element is required to have, for example, low ON-resistance and low switching loss in addition to high voltage. A current trend of the power semiconductor element is a field effect transistor formed on a semiconductor substrate mainly containing silicon. However, such a power semiconductor element is approaching the theoretical performance limit.

In this regard, attention is paid to a type of a semiconductor element (referred to as wide-bandgap power semiconductor element below) including a field effect transistor formed on a semiconductor substrate mainly containing a semiconductor material with a wider bandgap than that of silicon.

This is because the wide bandgap easily achieves a high voltage because of meaning a high dielectric breakdown strength.

If a semiconductor material itself has the high dielectric breakdown strength, the high voltage can be ensured even if a drift layer for keeping the high voltage is thinned, and therefore, an ON-resistance of the power semiconductor element can be reduced by, for example, the thinned drift layer and an increased impurity concentration.

That is, the wide-bandgap power semiconductor element is excellent in achieving both the improvement in the high voltage and the reduction in the ON-resistance which are in a trade-off relationship. Therefore, the wide-bandgap power semiconductor element is a promising semiconductor element achieving the high performance.

Examples of the semiconductor material with a wider bandgap than that of silicon are silicon carbide (SiC), gallium nitride (GaN), gallium oxide (Ga₂O₃), diamond and others. The following explanation will be made while attention is paid to the silicon carbide.

### <Background of Study>

The silicon carbide is a wide-bandgap semiconductor material with a wider bandgap than that of silicon. The silicon carbide is an interest semiconductor material in the power device field. For example, a stack substrate made of the silicon carbide used for the power devices includes an n-type buffer layer formed on an n-type silicon carbide substrate, and an n-type drift layer formed on the buffer layer. Generally, the buffer layer and the drift layer are formed by epitaxial growth.

However, the silicon carbide is of a plurality of polytypes with different arrangements of carbon atoms and silicon atoms are in a crystal layer structure direction (<0001> orientation). Difference in an internal energy among the polytypes is small. Thus, a polymorphic polytype tends to be formed in silicon carbide crystals. The formed polymorphic polytype becomes the crystal defect. Consequently, the stack substrate made of the silicon carbide contains more crystal defects than the stack substrate made of the silicon. Particularly, it is known that the presence of the "BPD" as a type of the crystal defect causes the degradation in forward current affecting the device properties.

The degradation in forward current in the power device may be caused as follows. That is, a hole caused in the forward current is captured by the "BPD." The degradation in forward current may be caused by the "SSF" extended by a recombination energy in recombination of the captured holes. Such a degradation in device properties is known as "bipolar degradation."

Thus, a technique of suppressing the formation of the "BPD" in a step of forming the drift layer by epitaxial growth has been studied. For example, when an off angle is set to 4 degrees, 95% or more of the "BPD" being in the drift layer formed by the epitaxial growth and being derived from the silicon carbide substrate can be structurally converted into the "TED." The "TED" does not degrade the forward current as different from the "BPD." Therefore, a technique of structurally-converting the "BPD" into the "TED" is useful in terms of the suppression of the degradation in forward current.

In order to suppress the hole carriers from reaching the "BPD" in the silicon carbide substrate, a dopant concentration of the buffer layer is increased thereby to shorten the hole-carrier lifetime. This suppresses the extension of the "SSF" due to the "BPD" in the silicon carbide substrate.

However, when the buffer layer includes the "BPD", the reaching of the hole carriers to the "BPD" in the buffer layer cannot be sufficiently suppressed. Thus, the "SSF" is extended by the "BPD" in the buffer layer, and, as a result, the "bipolar degradation" is highly likely to be caused. Therefore, it is desirable to reduce not only the "BPD" in the drift layer but also the "BPD" in the buffer layer.

From the above, in order to suppress the degradation in forward current of the power device to improve the long-term reliability of the power device, the inspection of the stack substrate made of the silicon carbide needs a technique of detecting not only the "BPD" in the drift layer but also the "BPD" in the buffer layer.

### <Study on Improvement>

A method of detecting the crystal defect in the stack substrate is exemplified to be an inspecting method of detecting the crystal defect by, for example, using a reflection image based on a reflected light caused by irradiation with a light on the drift layer and a photoluminescence image based on a photoluminescence light caused by irradiation with an excitation light on the drift layer. In the inspecting method, when a linear defect image is detected in the photoluminescence image while no defect image is detected in the reflection image, the detected defect can be classified as the "BPD."

However, in the inspecting method, even if the stack substrate is irradiated with the excitation light, the photoluminescence light is not detected from the "BPD" in the buffer layer with the short hole-carrier lifetime. Therefore, the inspecting method is difficult to detect the "BPD" in the buffer layer even if being capable of detecting the "BPD" in the drift layer.

There is an inspecting method of detecting the candidate region with the defect image of the "SSF" as the region including the "BPD" by irradiation with a high-irradiance ultraviolet ray on an entire stack substrate to extend the "SSF" into the "BPD" in the drift layer, the "BPD" in the buffer layer, and the "BPD" converted into the "TED" at the interface between the buffer layer and the silicon carbide substrate.

However, in this inspecting method, the irradiation with the high-irradiance ultraviolet ray (of, for example, 10W·cm²) on the entire staked substrate is set to a wavelength and an irradiance which reach the interface between the silicon carbide substrate and the buffer layer. In this case, when the ultraviolet ray reaches the "BPD" in the silicon carbide substrate, there is a risk of the extension of the "SSF" from the "BPD" in the silicon carbide substrate. This means that it is difficult to distinguish the "BPD" in the drift layer and the "BPD" in the buffer layer from each other. In addition, the "SSF" may be extended from the "BPD" in the silicon carbide substrate to be originally suppressed by forming the buffer layer. Consequently, there is a risk of degradation of the well-functioning drift layer and buffer layer without the "BPD".

As described above, in the existing inspecting methods, the "BPD" in the buffer layer is difficult to be detected without adverse influence on the stack substrate. Therefore, it is desirable to establish an inspecting method capable of detecting the "BPD" in the buffer layer.

Accordingly, the present embodiment employs a devisal for establishing the inspecting method capable of detecting the "BPD" in the buffer layer. The technical concept of the present embodiment will be described below.

### <Inspecting Method according to Embodiment>

The inspecting method according to the present embodiment is an inspecting method of detecting a crystal defect in the buffer layer by using a first image (reflection image) based on a reflected light caused by irradiation with a light on the buffer layer and a second image (photoluminescence image) based on a photoluminescence light caused by irradiation with an excitation light on the buffer layer. For example, an optical system for the irradiation with the light on the buffer layer may employ either a confocal optical system or a differential interference optical system, or a combination thereof.

In this inspecting method, as described above, currently, although the "BPD" in the drift layer can be detected, the "BPD" in the buffer layer is difficult to be detected. In this regard, the present inventors have newly found that the "BPD" in the buffer layer with the short hole-carrier lifetime can be detected, from studies focused on (1) a wavelength of the excitation light, (2) a cumulative irradiance of the excitation light, and (3) a light receiving filter. The findings will be described below.

An inspecting method of detecting the "BPD" present in the buffer layer will be described assuming that only the buffer layer is formed on a silicon carbide substrate.

### (1) Wavelength of Excitation Light

The wavelength of the excitation light may be, for example, equal to or less than 386 nm. However, the longer the wavelength of the excitation light is, the larger a penetration depth is. Thus, when an excitation light with a long wavelength is used, the excitation light penetrates into not only the buffer layer but also the silicon carbide substrate below the buffer layer. In this case, the photoluminescence light caused in the silicon carbide substrate is also received. That is, when an excitation light with a long wavelength is used, not only an amount of the received photoluminescence light caused in the buffer layer but also an amount of the received photoluminescence light caused in the silicon carbide substrate increase. This means that a noise component other than the photoluminescence light caused in the buffer layer increases. That is, when an excitation light with a long wavelength is used, the photoluminescence light (noise component) caused in the silicon carbide substrate increases relative to the photoluminescence light (signal component) caused in the buffer layer. In other words, the S/N ratio decreases. Thus, as the wavelength of the excitation light, a wavelength having a penetration depth as large as about a thickness of the buffer layer is desirably used. Therefore, the wavelength of the excitation light may be equal to or less than 386 nm, preferably equal to or less than 365 nm, and more preferably equal to or less than 313 nm.

### (2) Cumulative Irradiance of Excitation Light

An intensity of the photoluminescence light caused in the buffer layer is considerable to be high when the cumulative irradiance of the excitation light is high to some extent. If the intensity of the photoluminescence light caused in the buffer layer is higher, the photoluminescence light is more easily detected. Thus, the cumulative irradiance of the excitation light is desirably high to some extent in order to detect the photoluminescence light based on the "BPD" in the buffer layer. For example, the cumulative irradiance of the excitation light is desirably equal to or more than 1.6 W·cm⁻²·sec. Note that an upper limit of the cumulative irradiance of the excitation light is not particularly limited and may be within a common-sense range (in which the performance of the inspecting apparatus can be exerted). For example, the upper limit of the cumulative irradiance of the excitation light is preferably equal to or less than 8.7 W·cm⁻²·sec. The upper limit of the cumulative irradiance of the excitation light is more preferably equal to or less than 2.9 W·cm⁻²·sec.

### (3) Light Receiving Filter

The photoluminescence light caused in the buffer layer has a wavelength of a specific waveband. Thus, for the light receiving filter, it is preferably select a filter having a waveband transmitting the wavelength of the photoluminescence light caused in the buffer layer. This is because, if the light-transmitting waveband of the light receiving filter does not include the wavelength of the photoluminescence light caused in the buffer layer, the photoluminescence light is shieled by the light receiving filter and is difficult to be detected. Thus, it is important to select the light receiving filter. For example, it is preferable to select a light receiving filter having a light receiving wavelength that is equal to or longer than the wavelength of the excitation light and equal to or shorter than 399 nm.

The present inventors have studied inspecting conditions for detecting the "BPD" in the buffer layer, based on the above design concept. Table 1 shows observation study results of the "BPD" in the buffer layer.

**Table 1**

| | | | EXAMPLE 1 | EXAMPLE 2 | EXAMPLE 3 | EXAMPLE 4 | EXAMPLE 5 | EXAMPLE 6 | EXAMPLE 7 | EXAMPLE 8 |
|---|---|---|---|---|---|---|---|---|---|---|
| SAMPLE | FILM FORMATION PLANE | Si PLANE/C PLANE | Si PLANE | Si PLANE | Si PLANE | Si PLANE | Si PLANE | Si PLANE | Si PLANE | Si PLANE |
| SAMPLE | THICKNESS | *µ* m | 10 | 10 | 10 | 10 | 10 | 10 | 10 | 10 |
| SAMPLE | CONCENTRATION | cm⁻³ | 1 × 10¹⁸ | 1 × 10¹⁸ | 1 × 10¹⁷ | 1 × 10¹⁸ | 1 × 10¹⁸ | 1 × 10¹⁸ | 1 × 10¹⁸ | 1 × 10¹⁶ |
| SAMPLE | OFF ANGLE | deg. | 4 | 4 | 4 | 4 | 4 | 4 | 4 | 4 |
| SAMPLE | SUBSTRATE DIAMETER | mm | 150 | 150 | 150 | 150 | 150 | 150 | 150 | 150 |
| MEASURING CONDITION | IRRADIANCE | W· cm⁻² | 10 | 10 | 10 | 10 | 10 | 10 | 10 | 10 |
| MEASURING CONDITION | IRRADIANCE TIME | sec | 0.290 | 0.160 | 0.290 | 0.290 | 0.063 | 0.290 | 0.290 | 0.063 |
| MEASURING CONDITION | CUMULATIVE IRRADIANCE | W· cm⁻² ·sec | 2.90 | 1.60 | 2.90 | 2.90 | 0.63 | 2.90 | 2.90 | 0.63 |
| MEASURING CONDITION | FILTER | - | NUV | NUV | NUV | NUV | NUV | VIS | NIR | NIR |
| MEASURING CONDITION | FILTER WAVELENGTH | nm | 381 to 399 | 381 to 399 | 381 to 399 | 381 to 399 | 381 to 399 | 400 to 525 | 660 OR LONGER | 660 OR LONGER |
| RESULT | BPD DETECTION | ○/× | ○ | ○ | ○ | ○ | × | × | × | ○ |
| RESULT | CARRIER LIFETIME | O/× | ○ | ○ | ○ | ○ | ○ | ○ | ○ | × |

As a sample, a stack substrate in which only a buffer layer with a thickness of 10 µm is formed on the silicon carbide substrate is prepared. A dopant concentration of the buffer layer is set to be equal to or more than 1 × 10¹⁶ cm⁻³ and equal to or less than 3 × 10¹⁸ cm⁻³. It is studied whether the "BPD" is observed at a different cumulative irradiance of the excitation light and a different transmitting waveband of the light receiving filter. A machine "SICA88" manufactured by Lasertec Corporation is used as an inspecting apparatus. The wavelength of the excitation light is set to 313 nm.

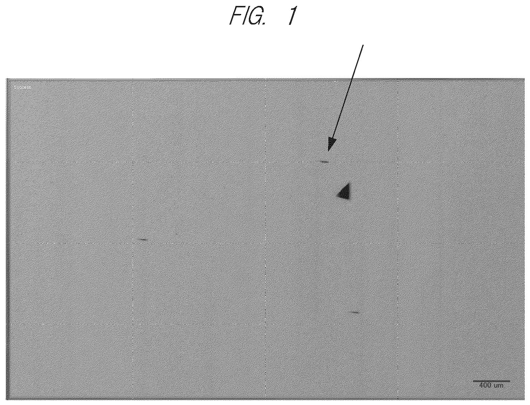

In Example 1 to Example 4, the dopant concentration of the buffer layer is equal to or more than 3 × 10¹⁷ cm⁻³ and equal to or less than 3 × 10¹⁸ cm⁻³. Thus, the hole-carrier lifetime in each of Example 1 to Example 4 is short, and therefore, the samples of Example 1 to Example 4 are suitable for the buffer layer. In Example 1 to Example 4, the cumulative irradiance of the excitation light is equal to or more than 1.6 W·cm⁻²·sec and equal to or less than 2.9 W·cm⁻²·sec. For the light receiving filter, NUV (light-transmitting wavelength is equal to or longer than 381 nm and equal to or shorter than 399 nm) is set. Consequently, the "BPD" in the buffer layer can be detected in Example 1 to Example 4. As illustrated in FIG. 1, the "BPD" is detected as the linear black defect (illustrated with an arrow) in the photoluminescence image of the NUV filter.

In Example 5, the cumulative irradiance of the excitation light is set to 0.63 W·cm⁻²·sec that is small. Consequently, the "BPD" in the buffer layer cannot be detected in Example 5.

In Example 6, for the light receiving filter, VIS (light-transmitting wavelength is equal to or longer than 400 nm and equal to or shorter than 525 nm) is set. Consequently, the "BPD" in the buffer layer cannot be detected in Example 6.

In Example 7, for the light receiving filter, NIR (light-transmitting wavelength is equal to or longer than 660 nm) is set. Consequently, the "BPD" in the buffer layer cannot be detected in Example 7.

In Example 8, the cumulative irradiance of the excitation light is set to 0.63 W·cm⁻²·sec that is small. For the light receiving filter, NIR (light-transmitting wavelength is equal to or longer than 660 nm) is set. Consequently, although the "BPD" in the buffer layer can be detected, the dopant concentration of the sample is 1 × 10¹⁶ cm⁻³ that is low. Thus, the sample in Example 8 is not suitable for the buffer layer due to the long hole-carrier lifetime.

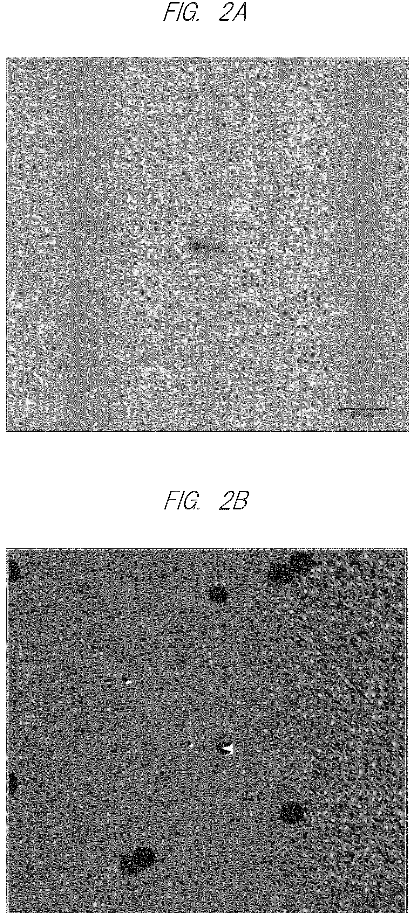

It is verified by a KOH etching method whether the linear black defect detected by the inspecting method is the "BPD". FIG. 2A illustrates a photoluminescence image of the NUV filter. FIG. 2B illustrates a surface image after the KOH etching. As illustrated in FIG. 2B, a shell-shaped etch pit due to the KOH etching specific to the "BPD" is observed. Thereby, it is found that the "BPD" has been detected by the inspecting method.

From the above, in the inspecting method of detecting the crystal defect in the buffer layer by using the first image (reflection image) based on the reflected light caused by the irradiation with the light on the buffer layer and the second image (photoluminescence image) based on the photoluminescence light caused by the irradiation with the excitation light on the buffer layer, it has been found that the detection of the "BPD" in the buffer layer with the short hole-carrier lifetime can be achieved by the employment of the inspecting conditions in which (1) the wavelength of the excitation light is 313 nm, in which (2) the cumulative irradiance of the excitation light is equal to or more than 1.6 W·cm⁻²·sec and equal to or less than 2.9 W·cm⁻²·sec, in which (3) the photoluminescence light is received by the light receiving filter, and in which (4) the light receiving filter is selected such that the light receiving wavelength is equal to or longer than the wavelength of the excitation light and equal to or shorter than 399 nm.

According to the present embodiment, the inspecting method of detecting the "BPD" in the buffer layer with the short hole-carrier lifetime can be established. Consequently, the stack substrate in which the "BPD" density in the buffer layer can be reduced can be manufactured by the employment of the inspecting method according to the present embodiment.

Specifically, in the present embodiment, the stack substrate in which the "BPD" density in the buffer layer can be reduced is achieved by the approach of providing the devisal to the manufacturing steps along with the employment of the established inspecting method. That is, in the present embodiment, the establishment of the inspecting method of detecting the "BPD" in the buffer layer becomes a motivator, and the approach of providing the devisal to the manufacturing steps is made to achieve the stack substrate in which the "BPD" density in the buffer layer can be reduced. Further, in the present embodiment, the stack substrate in which the "BPD" density in the buffer layer can be reduced is achieved by an approach of employing a novel configuration for the buffer layer along with the employment of the established inspecting method. That is, in the present embodiment, the establishment of the inspecting method of detecting the "BPD" in the buffer layer becomes a motivator, and two approaches that are the approach of providing the devisal to the manufacturing steps and the approach of employing the novel configuration for the buffer layer are made to achieve the stack substrate in which the "BPD" density in the buffer layer can be reduced.

Each of the approach of providing the devisal to the manufacturing steps and the approach of employing the novel configuration for the buffer layer will be described below.

### <Approach of providing Devisal to Manufacturing Steps>

### <<Configuration of Stack Substrate>>

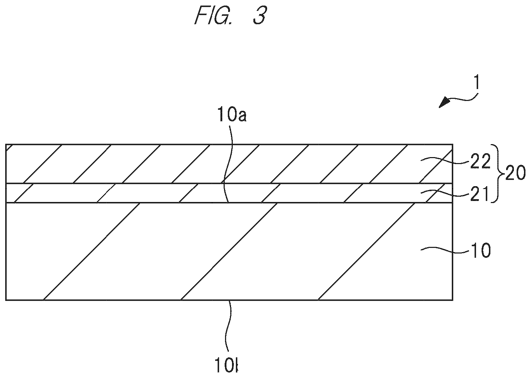

FIG. 3 is a diagram illustrating a configuration of a stack substrate 1.

In FIG. 3, the stack substrate 1 includes a silicon carbide substrate 10 and a silicon carbide epitaxial layer 20. The silicon carbide epitaxial layer 20 includes a buffer layer 21 and a drift layer 22. The silicon carbide substrate 10 has an upper surface (first surface) 10a and a lower surface (second surface) 10b opposite to the upper surface 10a. The silicon carbide epitaxial layer 20 is positioned on the upper surface 10a. The upper surface 10a has a (0001) Si plane. On the other hand, the lower surface 10b has a (000-1) C plane. The silicon carbide substrate 10 is made of silicon carbide single crystal. The polytype of the silicon carbide substrate 10 is desirably "4H". Note that the expression "made of A" described in the present specification means that "A" is contained as a main component, and intends to also include a dopant-containing A.

A size of the silicon carbide substrate 10 is not particularly limited. However, in terms of mass productivity of a semiconductor device manufactured under use of the stack substrate 1, the silicon carbide substrate 10 preferably has a diameter that is equal to or more than 100 mm. The silicon carbide substrate 10 more preferably has a diameter that is equal to or more than 145 mm (the diameter is, for example, 150 mm). The silicon carbide substrate 10 more preferably has a diameter that is equal to or more than 195 mm (the diameter is, for example, 200 mm).

The silicon carbide substrate 10 has a thickness defined by a diameter based on specifications. For example, when the diameter is 100 mm or 150 mm, the thickness of the silicon carbide substrate 10 is 350 µm ± 25 µm or 500 µm ± 25 µm.

The silicon carbide substrate 10 is preferably an off-angle substrate with an off angle θ. The off angle θ is preferably equal to or more than 0.5 degrees and equal to or less than 8 degrees. The off angle θ is more preferably equal to or more than 0.5 degrees and equal to or less than 5 degrees.

The properties of the upper surface 10a of the silicon carbide substrate 10 will be described in detail.

The upper surface 10a is preferably polished by a chemical mechanical polishing (CMP) method. Specifically, the upper surface 10a is preferably polished by the CMP method until the surface roughness Ra of the upper surface 10a is equal to or less than 1 nm. The upper surface 10a is more preferably polished by the CMP method until the surface roughness Ra of the upper surface 10a is equal to or less than 0.2 nm. The surface roughness Ra can be measured by, for example, a white light interferometry. For example, the surface roughness Ra of the upper surface 10a is a value obtained by measuring and averaging three points on the upper surface 10a at a length of 100 µm. The surface roughness Ra may be ideally 0 nm, but cannot be actually 0 nm. Thus, a lower limit of a preferable range of the surface roughness Ra is higher than 0.

The buffer layer 21 is formed on the upper surface 10a of the silicon carbide substrate 10 by the epitaxial growth method. A thickness of the buffer layer 21 is optionally set depending on the performance required for the semiconductor device manufactured under the use of the stack substrate 1. For example, the thickness of the buffer layer 21 is about equal to or more than 0.5 µm and equal to or less than 10 µm.

The drift layer 22 is formed on the buffer layer 21 by the epitaxial growth method. A thickness of the drift layer 22 is optionally set depending on the performance required for the semiconductor device manufactured under the use of the stack substrate 1. For example, the thickness of the drift layer 22 is about equal to or more than 3 µm and equal to or less than 100 µm.

### <<Method of Manufacturing Stack Substrate>>

Next, a method of manufacturing the stack substrate 1 will be described.

First, the silicon carbide substrate 10 is prepared. The silicon carbide substrate 10 has the plane orientation and the off angle as described above. The upper surface 10a of the silicon carbide substrate 10 is polished by the CMP method to adjust the surface roughness Ra to be equal to or less than 1 nm. The smaller surface roughness Ra is more preferable. Thus, for example, a commercially available silicon carbide substrate may be prepared first, and then, its upper surface 10a may be polished by the CMP method. A step of wet-etching the upper surface 10a and a step of oxidizing the upper surface 10a with gas may be performed in addition to the step of polishing the upper surface by the CMP method. Additionally, combination of the polishing step by the CMP method, the wet-etching step, and the oxidizing step may be performed a plurality of times as needed.

Next, the silicon carbide epitaxial layer 20 is formed. In order to form the silicon carbide epitaxial layer 20 with uniform properties on the silicon carbide substrate 10, the silicon carbide epitaxial layer 20 is preferably formed by a chemical vapor deposition (CVD) method.

For example, the silicon carbide substrate 10 is loaded into a growth chamber of a CVD apparatus, and then, the silicon carbide substrate 10 is arranged on a holder such that the upper surface 10a of the (0001) Si plane is faced upward. Then, the silicon carbide substrate 10 is heated at a temperature that is equal to or higher than 1500 °C and equal to or lower than 1800 °C. Thereafter, carrier gas, gas as a source of carbon, gas as a source of silicon, and gas as dopant are introduced into the growth chamber thereby to grow the silicon carbide epitaxial layer 20 on the silicon carbide substrate 10. The carrier gas is, for example, hydrogen (H₂) gas. The gas as the source of carbon in the source gas is, for example, propane (C₃H₈) gas. The gas as the source of silicon in the source gas is, for example, silane (SiH₄) gas. The gas as the dopant is, for example, nitrogen (N₂) gas.

Note that the upper surface 10a of the silicon carbide substrate 10 may be cleaned by introducing only the carrier gas into the growth chamber before growing the silicon carbide epitaxial layer 20.

In forming the buffer layer 21, a flowrate of the nitrogen gas is adjusted to achieve a predetermined dopant concentration. Alternatively, a flowrate of the carrier gas or the source gas is changed to change a doping rate of nitrogen as the dopant to be introduced into the buffer layer 21, thereby achieving a predetermined dopant concentration.

Even in forming the drift layer 22, a flowrate of nitrogen is similarly adjusted to achieve a predetermined dopant concentration. Alternatively, the flowrate of the carrier gas or the source gas is changed to change a doping rate of nitrogen as the dopant to be introduced into the drift layer 22, thereby achieving a predetermined dopant concentration.

The ratio (C/Si) of the carbon in the gas as the source of carbon to be introduced relative to the silicon in the gas as the source of silicon is preferably equal to or higher than 1. Specifically, the C/Si is preferably equal to or higher than 1 and equal to or lower than 1.6. If the C/Si is higher than 1.6, the defect density in each of the buffer layer 21 and the drift layer 22 increases. To the contrary, if the C/Si is less than 1 such that the silane is excessively supplied, Si droplets which are aggregated Si are generated on the surface of the silicon carbide epitaxial layer 20 in the course of the growth of the silicon carbide epitaxial layer 20. In this case, a defect based on the Si droplets is formed, and therefore, is not preferable.

Note that a pressure in the growth chamber in the course of the growth of the silicon carbide epitaxial layer 20 is, for example, preferably equal to or higher than 10 kPa and equal to or lower than 50 kPa.

### <<Devisal in Manufacturing Steps>>

In the present embodiment, a devisal is made to a method of manufacturing a product substrate (stack substrate 1) in order to reduce the "BPD" density in the buffer layer 21. Specifically, the "BPD" density in the buffer layer is reduced by the employment of the established inspecting method according to the present embodiment. The devisal in the manufacturing steps will be described below.

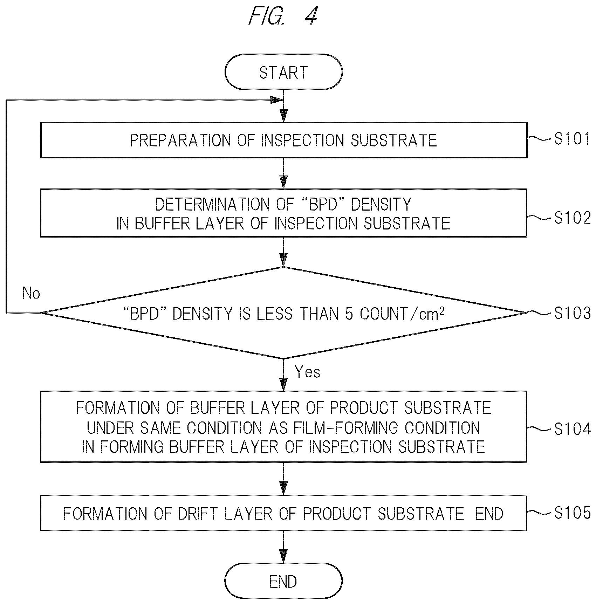

The product substrate is, for example, the stack substrate 1 illustrated in FIG. 3. That is, the product substrate includes the silicon carbide substrate, the buffer layer formed on the silicon carbide substrate, and the drift layer formed on the buffer layer. A semiconductor device is manufactured under use of the product substrate configured as described above. In the product substrate, it is important to reduce the "BPD" density in the buffer layer. Thus, the product substrate is manufactured along a flowchart illustrated in FIG. 4.

A method of manufacturing the product substrate in which the "BPD" density in the buffer layer can be reduced will be described below with reference to FIG. 4. FIG. 4 is the flowchart illustrating a flow of manufacturing steps for manufacturing the product substrate in which the "BPD" density in the buffer layer is low.

First, an inspection substrate is prepared (S101). The inspection substrate is a stack substrate including only the silicon carbide substrate and the buffer layer formed on the silicon carbide substrate. That is, the drift layer is not formed on the buffer layer in the inspection substrate. The inspection substrate is used to evaluate the "BPD" density in the buffer layer formed on the silicon carbide substrate. That is, the inspection substrate is prepared, and then, the "BPD" density in the buffer layer of the inspection substrate is determined under the employment of the inspecting method of detecting the crystal defect in the buffer layer (S102).

Specifically, in the inspecting method of detecting the crystal defect in the buffer layer, the crystal defect in the buffer layer is detected by using the reflection image (first image) based on the reflected light caused by the irradiation with the light on the buffer layer and the photoluminescence image (second image) based on the photoluminescence light caused by the irradiation with the excitation light on the buffer layer.

The inspecting method described here employs the following inspecting conditions.
(1) The wavelength of the excitation light is 313 nm.
(2) The cumulative irradiance of the excitation light is equal to or more than 1.6 W·cm⁻²·sec and equal to or less than 2.9 W·cm⁻²·sec.
(3) The photoluminescence light is received through the light receiving filter.
(4) The light receiving filter is selected such that the light receiving wavelength is equal to or longer than the wavelength of the excitation light and equal to or shorter than 399 nm.

The "BPD" density in the buffer layer of the inspection substrate is determined as described above. If the determined "BPD" density in the buffer layer is equal to or more than 5 cm⁻² (S103), a new inspection substrate including a buffer layer which is formed under new film forming conditions is prepared (S101). To the contrary, if the determined "BPD" density in the buffer layer is equal to or more than 0 cm⁻² and less than 5 cm⁻² (S103), a buffer layer of the product substrate is formed under the same conditions as the film forming conditions for forming the buffer layer of the inspection substrate (S104).

Thereafter, the drift layer is formed on the buffer layer in the product substrate (S105).

As described above, the buffer layer of the product substrate can be formed under the same film forming conditions as the conditions for forming the buffer layer of the inspection substrate in which the "BPD" density in the buffer layer is less than 5 cm⁻². Consequently, a high-quality product substrate in which the "BPD" density in the buffer layer of the product substrate is low can be manufactured. Thereby, for example, the product substrate in which the "BPD" density in the buffer layer is less than 5 cm⁻² can be manufactured. That is, the product substrate in which the "BPD" density in the buffer layer can be reduced can be achieved by the approach of providing the devisal to the manufacturing steps along with the employment of the established inspecting method (approach of achieving the manufacturing flow in FIG. 4).

The following explanation is about an example of evaluating a plurality of the inspection substrates each including the buffer layer formed while specifically changing the film forming condition in the manufacturing flow in FIG. 4. Table 2 is a table showing evaluation results of the inspection substrates each including the buffer layer formed while changing the film forming condition.

**Table 2**

| | | | EXAMPLE A | EXAMPLE B | EXAMPLE C | EXAMPLE D | EXAMPLE E |
|---|---|---|---|---|---|---|---|
| FILM FORMING CONDITION | - | - | CONDITION A | CONDITION B | CONDITION C | CONDITION D | CONDITION E |
| FILM FORMING CONDITION | TEMPERATURE | °C | 1600 | 1600 | 1600 | 1600 | 1600 |
| FILM FORMING CONDITION | PRESSURE | kPa | 30 | 30 | 30 | 30 | 30 |
| FILM FORMING CONDITION | SiH₄ FLOW RATE | slm | 0.2 | 0.2 | 0.2 | 0.2 | 0.2 |
| FILM FORMING CONDITION | C₃H₈ FLOW RATE | slm | 0.1 | 0.1 | 0.1 | 0.1 | 0.1 |
| FILM FORMING CONDITION | N₂ FLOW RATE | slm | 0.1 | 0.1 | 0.03 | 0.3 | 1 |
| FILM FORMING CONDITION | H₂ FLOW RATE | slm | 150 | 150 | 150 | 150 | 150 |
| SAMPLE | FILM FORMATION PLANE | Si PLANE/ C PLANE | Si 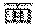 | Si 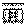 | Si 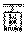 | Si 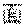 | Si 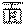 |
| SAMPLE | THICKNESS | *µ* m | 10 | 10 | 10 | 10 | 10 |
| SAMPLE | CONCENTRATION | cm⁻³ | 1 × 10¹⁸ | 1 × 10¹⁸ | 3 × 10¹⁷ | 3 × 10¹⁸ | 1 × 10¹⁹ |
| SAMPLE | OFF ANGLE | deg. | 4 | 4 | 4 | 4 | 4 |
| SAMPLE | SUBSTRATE DIAMETER | mm | 150 | 150 | 150 | 150 | 150 |
| MEASURING CONDITION | IRRADIANCE | W· cm⁻² | 10 | 10 | 10 | 10 | 10 |
| MEASURING CONDITION | IRRADIANCE TIME | sec | 0.290 | 0.290 | 0.290 | 0.290 | 0.290 |
| MEASURING CONDITION | CUMULATIVE IRRADIANCE | W· cm⁻² ·sec | 2.90 | 2.90 | 2.90 | 2.90 | 2.90 |
| MEASURING CONDITION | FILTER | - | NUV | NUV | NUV | NUV | NUV |
| MEASURING CONDITION | FILTER WAVELENGTH | nm | 381 to 399 | 381 to 399 | 381 to 399 | 381 to 399 | 381 to 399 |
| RESULT | COUNT OF BPD | - | 71 | 292 | 3 | 896 | 1500 |
| RESULT | BPD DENSITY | cm⁻² | 0.46 | 1.90 | 0.02 | 5.82 | 9.74 |
| RESULT | BPD DENSITY | O/× | ○ | ○ | ○ | × | × |

A method of manufacturing the inspection substrate will be described. First, the silicon carbide substrate is prepared. The silicon carbide substrate is preferably an off-angle substrate. The silicon carbide substrate is preferably an off-angle substrate with an off angle θ. Specifically, the first surface or a normal line of the first surface is preferably tilted by θ from the [0001] orientation toward the [1120] orientation. A substrate with an off angle of 4 ° is used herein. The off angle θ is preferably equal to or more than 0.5° and equal to or less than 8°, and more preferably equal to or more than 0.5° and equal to or less than 5°. The surface roughness Ra of the first surface of the silicon carbide substrate is adjusted to be equal to or less than 1 nm by the CMP method. The surface roughness Ra preferably has a lower value. In addition to the step of performing the CMP method, a step of wet-etching the first surface and a step of oxidizing the first surface by using gas may be performed, or combination of these three steps may be performed twice or more as needed. Next, the buffer layer is formed. Any forming method may be applicable if the apparatus can epitaxially grow the buffer layer to be formed. The buffer layer is preferably formed by a CVD apparatus using the chemical vapor deposition method since the CVD apparatus can epitaxially grow the buffer layer to be formed with uniform properties on a large-diameter silicon carbide substrate. For example, the silicon carbide substrate is loaded into a growth chamber of the CVD apparatus, and is arranged on the holder such that the first surface as the (0001) Si plane faces upward. The silicon carbide substrate is heated to a temperature of about 1600 °C, and the carrier gas, the gas as the source of carbon, the gas as the source of silicon, and the gas as the dopant are introduced into the growth chamber, thereby epitaxially growing the buffer layer to be formed. As the carrier gas, for example, hydrogen (H₂) or the like can be used. As the gas as the source of carbon in the source gas, propane (C₃H₈) or the like can be used. As the gas as the source of silicon in the source gas, silane (SiH₄) or the like can be used. As the gas as the dopant, nitrogen (N₂) or the like can be used. Before epitaxially growing the buffer layer to be formed, only the carrier gas may be introduced into the growth chamber to clean the first surface of the silicon carbide substrate. Each flowrate of the carrier gas, the gas as the source of carbon, the gas as the source of silicon, and the gas as the dopant is adjusted such that the dopant concentration of the buffer layer is uniform in the wafer surface at the value of Table 1. A pressure in the growth chamber during the epitaxial growth of the buffer layer is set to 30 kPa. However, the pressure is not limited thereto if the dopant concentration of the buffer layer is uniform in the wafer surface at the value of Table 1. In Example A to Example E, a thickness of each of the buffer layers is 10 µm in common. The "BPD" density in the buffer layer of the inspection substrate in each of Example A to Example E is evaluated by the inspecting method established according to the present embodiment. Table 2 shows that a case in which the evaluated "BPD" density is less than 5 cm⁻² is evaluated to be "O". To the contrary, Table 2 also shows that a case in which the evaluated "BPD" density is equal to or more than 5 cm⁻² is evaluated to be "×". That is, the evaluation results of Table 2 reveal that the "BPD" density is excellent in the inspection substrate in each of Example A to Example C. To the contrary, the evaluation results of Table 2 also reveal that the "BPD" density is not excellent in the inspection substrate in each of Example D and Example E.

In the manufacturing flow in FIG. 4, it is assumed that, for example, the inspection substrate in Example A is prepared as the inspection substrate (S101). In this case, the "BPD" density in the buffer layer is determined by the inspecting method established according to the present embodiment (S102). Consequently, as shown in Table 2, the "BPD" density in the buffer layer is 0.46 cm⁻². That is, the "BPD" density in the buffer layer of the inspection substrate in Example A is less than 5 cm⁻² (S103). Thus, the buffer layer of the product substrate is formed under the same conditions as the film forming conditions A for forming the buffer layer on the inspection substrate in Example A (S104). Thereby, a high-quality product substrate in which the "BPD" density in the buffer layer of the product substrate is low can be manufactured.

In the manufacturing flow in FIG. 4, it is assumed that, for example, the inspection substrate in Example B is prepared as the inspection substrate (S101). In this case, the "BPD" density in the buffer layer is determined by the inspecting method established according to the present embodiment (S102). Consequently, as shown in Table 2, the "BPD" density in the buffer layer is 1.90 cm⁻². That is, the "BPD" density in the buffer layer of the inspection substrate in Example B is less than 5 cm⁻² (S103). Thus, the buffer layer of the product substrate is formed under the same conditions as the film forming conditions B for forming the buffer layer on the inspection substrate in Example B (S104). Thereby, a high-quality product substrate in which the "BPD" density in the buffer layer of the product substrate is low can be manufactured.

In the manufacturing flow in FIG. 4, it is assumed that, for example, the inspection substrate in Example C is prepared as the inspection substrate (S101). In this case, the "BPD" density in the buffer layer is determined by the inspecting method established according to the present embodiment (S102). Consequently, as shown in Table 2, the "BPD" density in the buffer layer is 0.02 cm⁻². That is, the "BPD" density in the buffer layer of the inspection substrate in Example C is less than 5 cm⁻² (S103). Thus, the buffer layer of the product substrate is formed under the same conditions as the film forming conditions C for forming the buffer layer on the inspection substrate in Example C (S104). Thereby, a high-quality product substrate in which the "BPD" density in the buffer layer of the product substrate is low can be manufactured.

In the manufacturing flow in FIG. 4, it is assumed that, for example, the inspection substrate in Example D is prepared as the inspection substrate (S101). In this case, the "BPD" density in the buffer layer is determined by the inspecting method established according to the present embodiment (S102). Consequently, as shown in Table 2, the "BPD" density in the buffer layer is 5.82 cm⁻². That is, the "BPD" density in the buffer layer of the inspection substrate in Example D is equal to or more than 5 cm⁻² (S103). Thus, if the buffer layer of the product substrate is formed under the same conditions as the film forming conditions D for forming the buffer layer on the inspection substrate in Example D, there is a risk of manufacture of the product substrate in which the "BPD" density in the buffer layer of the product substrate is high. Thus, in this case, the buffer layer of the product substrate is not formed under the film forming conditions D. Then, a new inspection substrate including a buffer layer formed under different film forming conditions from the film forming conditions D is prepared (S101). Thereafter, the steps in the manufacturing flow in FIG. 4 are repeatedly performed.

In the manufacturing flow in FIG. 4, it is assumed that, for example, the inspection substrate in Example E is prepared as the inspection substrate (S101). In this case, the "BPD" density in the buffer layer is determined by the inspecting method established according to the present embodiment (S102). Consequently, as shown in Table 2, the "BPD" density in the buffer layer is 9.74 cm⁻². That is, the "BPD" density in the buffer layer of the inspection substrate in Example E is equal to or more than 5 cm⁻² (S103). Thus, if the buffer layer of the product substrate is formed under the same conditions as the film forming conditions E for forming the buffer layer on the inspection substrate in Example E, there is a risk of manufacture of the product substrate in which the "BPD" density in the buffer layer of the product substrate is high. Thus, in this case, the buffer layer of the product substrate is not formed under the film forming conditions E. Then, a new inspection substrate including a buffer layer formed under different film forming conditions from the film forming conditions E is prepared (S101). Thereafter, the steps in the manufacturing flow in FIG. 4 are repeatedly performed.

As described above, in the case of the use of the inspection substrate in each of Example A to Example C, the buffer layer of the product substrate is formed under the same conditions as the film forming conditions A, B, or C. Thereby, the high-quality product substrate in which the "BPD" density in the buffer layer of the product substrate is low can be manufactured. To the contrary, in the case of the use of the inspection substrate in each of Example D and Example E, the buffer layer of the product substrate is not formed under the film forming conditions D or E. Thereby, a low-quality product substrate in which the "BPD" density in the buffer layer is high can be prevented from being manufactured.

From the above, the product substrate having the following configuration can be manufactured.
(1) The product substrate includes a silicon carbide substrate, a buffer layer formed on the silicon carbide substrate, and a drift layer formed on the buffer layer, and a "basal plane dislocation (BPD)" density in the buffer layer is equal to or more than 0 cm⁻² and less than 5 cm⁻².
(2) A dopant concentration of the buffer layer is equal to or more than 3 × 10¹⁷ cm⁻³ and equal to or less than 1 × 10¹⁹ cm⁻ 3
(3) The "BPD" density in the buffer layer is determined by the inspecting method according to the present embodiment.
(4) The dopant concentration of the buffer layer is higher than a dopant concentration of the drift layer.

### <<Technical Significance of Manufacturing Flow in FIG. 4>>

Next, the technical significance of the manufacturing flow in FIG. 4 will be described.

For example, the "BPD" density in the buffer layer of the product substrate may be directly inspected by the inspecting method established according to the present embodiment without the use of the inspection substrate.

In this regard, the inspecting method established according to the present embodiment can achieve excellent detection accuracy when the thickness of the buffer layer is about 10 µm. That is, the inspecting method established according to the present embodiment employs the excitation light with a wavelength of 313 nm. The penetration depth of the excitation light is about 10 µm. That is, when the thickness of the buffer layer is about 10 µm, only the buffer layer can be irradiated with the excitation light. In other words, when the thickness of the buffer layer is about 10 µm, the excitation light does not reach the silicon carbide substrate below the buffer layer. Therefore, in the inspecting method established according to the present embodiment, when the thickness of the buffer layer is about 10 µm, the influence of the photoluminescence light based on the "BPD" in the silicon carbide substrate can be reduced (noise component can be reduced). That is, when the thickness of the buffer layer is about 10 µm, the "BPD" density in the buffer layer can be accurately detected by the inspecting method established according to the present embodiment.

A designed value of the thickness of the buffer layer of the product substrate described here is different depending on the performance required for the semiconductor device. For example, the thickness of the buffer layer is designed at a different value depending on the high voltage required for the semiconductor device. For example, the thickness of the buffer layer of the product substrate is about equal to or more than 0.5 µm and equal to or less than 10 µm. Thus, when the "BPD" density in the buffer layer of the product substrate is directly inspected by the inspecting method established according to the present embodiment, the buffer layer thinner than about 10 µm may be inspected. In this case, the excitation light with the wavelength of 313 nm reaches the silicon carbide substrate below the buffer layer. Consequently, the influence of the photoluminescence light based on the "BPD" in the silicon carbide substrate increases, and the "BPD" density in the buffer layer is difficult to be accurately detected.

Thus, the manufacturing flow in FIG. 4 is employed as the approach of providing the devisal to the manufacturing steps according to the present embodiment. That is, a method of indirectly inspecting the "BPD" density in the buffer layer of the product substrate by the inspection method established according to the present embodiment of inspecting the inspection substrate is employed. Specifically, the inspection substrate is prepared such that the thickness of the buffer layer formed on the silicon carbide substrate is about 10 µm, and the "BPD" density in the buffer layer of the inspection substrate is inspected. In this case, the thickness of the buffer layer is about 10 µm, and thus, the "BPD" density in the buffer layer can be accurately inspected by the inspecting method established according to the present embodiment. If the "BPD" density in the buffer layer of the inspection substrate is low as a result of the inspection, the product substrate including the buffer layer with a predetermined thickness is manufactured under the same film forming conditions as the film forming conditions for forming the buffer layer of the inspection substrate. Thereby, the high-quality product substrate including the buffer layer with the low "BPD" density can be manufactured. As described above, the technical significance of the employment of the manufacturing flow in FIG. 4 is that the high-quality product substrate including the buffer layer with the low "BPD" density can be stably manufactured irrespective of the thickness of the buffer layer of the product substrate. That is, the technical significance of the employment of the manufacturing flow in FIG. 4 is large in that the indirect inspection of the product substrate through the inspection of the inspection substrate provides the technical idea capable of maximizing the performance of the inspecting method established according to the present embodiment, irrespective of the thickness of the buffer layer formed on the product substrate.

From the above, in employing the manufacturing flow in FIG. 4, it is important to use the inspection substrate. A feature point of the inspection substrate is that the inspection substrate has the following configuration (1) or (2).
(1) The inspection substrate includes the buffer layer and is used for determining the film forming conditions for forming the buffer layer of the product substrate, and the thickness of the buffer layer of the inspection substrate is larger than the thickness of the buffer layer of the product substrate.
(2) The inspection substrate includes the buffer layer and is used for determining the film forming conditions for forming the buffer layer of the product substrate, and the thickness of the buffer layer of the inspection substrate is larger than 0.5 µm.

### <Approach of employing Novel Configuration for Buffer Layer>

The "BPD" density in the buffer layer can be evaluated by the inspecting method established according to the present embodiment. Thus, the "BPD" density in the buffer layer in a novel configuration for the buffer layer can be evaluated. Thus, it can be evaluated whether the novel configuration for the buffer layer is useful for achieving the high-quality stack substrate including the buffer layer with the low "BPD" density by the use of the inspecting method established according to the present embodiment. That is, the inspecting method established according to the present embodiment is useful because of evaluating the novel configuration for the buffer layer.

In the present embodiment, the stack substrate in which the "BPD" density in the buffer layer can be reduced is achieved by the approach of employing the novel configuration for the buffer layer along with the use of the established inspecting method. The following explanation is made about the achievement of the stack substrate in which the "BPD" density in the buffer layer can be reduced by the approach of employing the novel configuration for the buffer layer.

### <<Background of Study>>

The stack substrate includes the silicon carbide substrate, the buffer layer, and the drift layer. The buffer layer is formed on the silicon carbide substrate. The drift layer is formed on the buffer layer. The dopant concentration (nitrogen concentration) of the silicon carbide substrate is, for example, about equal to or more than 5 × 10¹⁸ cm⁻³ and equal to or less than 1 × 10¹⁹ cm⁻³. The dopant concentration (nitrogen concentration) of the buffer layer is, for example, about 1 × 10¹⁸ cm⁻³. The dopant concentration (nitrogen concentration) of the drift layer is, for example, about equal to or more than 1 × 10¹⁵ cm⁻³ and equal to or less than 3 × 10¹⁶ cm⁻³.

The buffer layer has a function of suppressing the defect growth caused from the silicon carbide substrate to the drift layer. The buffer layer has a function of capturing a hole flowing from the drift layer during the conduction of the semiconductor device to prevent the hole from reaching the silicon carbide substrate. That is, the buffer layer has a function of suppressing the extension of the "SSF" based on the "BPD" in the silicon carbide substrate. In other words, the buffer layer has a function of suppressing the "bipolar degradation." In order to fully exert the functions, it is preferable to reduce the "BPD" in the buffer layer.

As described above, the dopant concentration of the buffer layer is generally about 1 × 10¹⁸ cm⁻³. The dopant concentration (nitrogen concentration) of the silicon carbide substrate is, for example, about equal to or more than 5 × 10¹⁸ cm⁻³ and equal to or less than 1 × 10¹⁹ cm⁻³. As described above, a difference between the dopant concentration of the buffer layer and the dopant concentration of the silicon carbide substrate is small. This means that a difference in a lattice constant is small at the interface between the buffer layer and the silicon carbide substrate. Thus, the interface between the buffer layer and the silicon carbide substrate is less distorted. Consequently, the present inventors have presumed that the efficiency in converting the "BPD" in the silicon carbide substrate into the "TED" that is harmless in the buffer layer is reduced. Thus, in order to reduce the "BPD" in the buffer layer, it is important to improve the efficiency in converting the "BPD" into the "TED". In this regard, in consideration of the presumption (findings) of the present inventors, it is presumed that the "BPD" density in the buffer layer closely relates with the difference between the dopant concentration of the buffer layer and the dopant concentration of the silicon carbide substrate. Thus, the relationship between the dopant concentration of the buffer layer and the "BPD" density in the buffer layer is evaluated by the use of the inspecting method established according to the present embodiment. Specifically, the inspecting method established according to the present embodiment is suitable for the inspection under the configuration in which the thickness of the buffer layer is about 10 µm. Thereby, the relationship between the dopant concentration of the buffer layer and the "BPD" density in the buffer layer is evaluated by use of a sample in which the buffer layer with the thickness of 10 µm is formed on the silicon carbide substrate. Particularly, the relationship between the dopant concentration of the buffer layer and the "BPD" density in the buffer layer is evaluated while changing the dopant concentration of the buffer layer.

Consequently, it has been found that the "BPD" in the buffer layer almost disappears when the dopant concentration of the buffer layer is equal to or less than 3 × 10¹⁶ cm⁻³. The present inventors have presumed that this is caused by an increase in the difference in the lattice constant at the interface between the buffer layer and the silicon carbide substrate in response to an increase in the difference between the dopant concentration of the buffer layer and the dopant concentration of the silicon carbide substrate. That is, the interface between the buffer layer and the silicon carbide substrate is more distorted by the increase in the difference in the lattice constant. Thereby, the present inventors have presumed that the efficiency in converting the "BPD" in the silicon carbide substrate into the "TED" that is harmless in the buffer layer is improved. Thus, in order to reduce the "BPD" density in the buffer layer, it is preferable to reduce the dopant concentration of the buffer layer. However, according to the study made by the present inventors, a room to be improved is caused by the low dopant concentration of the buffer layer. The room to be improved caused by the low dopant concentration of the buffer layer will be explained below.

### <<Study on Improvement>>

As described above, the low dopant concentration of the buffer layer can reduce the "BPD" density in the buffer layer. To the contrary, as the function of the buffer layer, the shortening of the hole-carrier lifetime in the buffer layer due to the high dopant concentration of the buffer layer to suppress the degradation in forward current is exemplified. Thus, the low dopant concentration of the buffer layer increases the hole-carrier lifetime in the buffer layer, and thus, reduces the function of suppressing the degradation in forward current. Further, the low dopant concentration of the buffer layer increases the ON-resistance of the semiconductor device. This degrades the performance of the semiconductor device. Furthermore, because of an increase in Joule heat due to the increase in the ON-resistance, there is a concern about a decrease in the reliability of the semiconductor device.

As described above, in terms of the dopant concentration of the buffer layer, a trade-off relationship is established between the reduction in the "BPD" density in the buffer layer and the suppression on the degradation in forward current and the suppression on the increase in ON-resistance. Thus, it is preferable to develop a novel configuration for achieving both the reduction in the "BPD" density in the buffer layer and the suppression on the degradation in forward current and the suppression on the increase in ON-resistance which are in the trade-off relationship. Therefore, the following explanation is made about the novel configuration for achieving both the reduction in the "BPD" density in the buffer layer and the suppression on the degradation in forward current and the suppression on the increase in ON-resistance.

### <<Novel Configuration for Buffer Layer>>

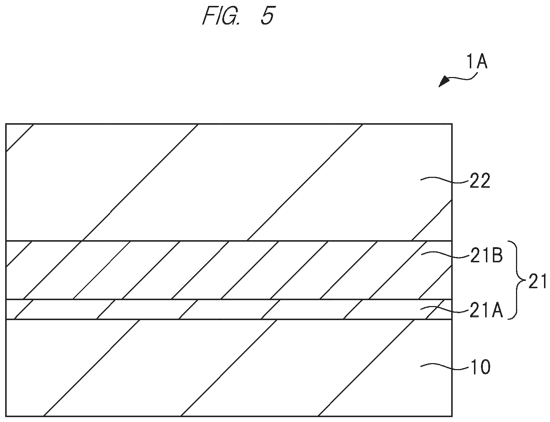

FIG. 5 is a diagram illustrating a configuration of a stack substrate 1A including the buffer layer with the novel configuration.

In FIG. 5, the stack substrate 1A includes the silicon carbide substrate 10, the buffer layer 21, and the drift layer 22. The buffer layer 21 is made of a low-concentration buffer layer 21A and a high-concentration buffer layer 21B. The low-concentration buffer layer is formed on the silicon carbide substrate 10. The high-concentration buffer layer 21B is formed on the low-concentration buffer layer 21A. The drift layer 22 is formed on the high-concentration buffer layer 21B. Nitrogen as an n-type dopant is introduced into each of the silicon carbide substrate 10, the buffer layer 21, and the drift layer 22.

The second dopant concentration of the low-concentration buffer layer 21A is lower than the first dopant concentration of the silicon carbide substrate 10. The third dopant concentration of the high-concentration buffer layer 21B is higher than the second dopant concentration of the low-concentration buffer layer 21A and lower than the first dopant concentration of the silicon carbide substrate 10. The fourth dopant concentration of the drift layer 22 is lower than the third dopant concentration of the high-concentration buffer layer 21B. The first dopant concentration of the silicon carbide substrate 10 is, for example, equal to or more than 5 × 10¹⁸ cm⁻³ and equal to or less than 1 × 10¹⁹ cm⁻³. The second dopant concentration of the low-concentration buffer layer 21A may be, for example, equal to or more than 1 × 10¹⁴ cm⁻³ and less than 1 × 10¹⁶ cm⁻³. The second dopant concentration of the low-concentration buffer layer 21A may be, for example, equal to or more than 1 × 10¹⁵ cm⁻³ and less than 1 × 10¹⁶ cm⁻³. Note that the low second dopant concentration increases the resistance value. Thus, if it is most important to suppress an increase in the resistance value, the second dopant concentration of the low-concentration buffer layer 21A is preferably equal to or more than 1 × 10¹⁶ cm⁻³ to be a prerequisite of being lower than the first dopant concentration of the silicon carbide substrate 10. The third dopant concentration of the high-concentration buffer layer 21B is equal to or more than 1 × 10¹⁷ cm⁻³. The third dopant concentration of the high-concentration buffer layer 21B is preferably, for example, equal to or more than 1 × 10¹⁷ cm⁻³ and equal to or less than 5 × 10¹⁸ cm⁻³. The third dopant concentration of the high-concentration buffer layer 21B is more preferably equal to or more than 3 × 10¹⁷ cm⁻³ and equal to or less than 3 × 10¹⁸ cm⁻³. The third dopant concentration of the high-concentration buffer layer 21B is more preferably equal to or more than 5 × 10¹⁷ cm⁻³ and equal to or less than 2 × 10¹⁸ cm⁻³. The fourth dopant concentration of the drift layer 22 is equal to or more than 1 × 10¹⁵ cm⁻³ and less than 3 × 10¹⁶ cm⁻³.

The stack substrate 1A configured as described above includes the buffer layer 21 made of the low-concentration buffer layer 21A and the high-concentration buffer layer 21B. In the present specification, the buffer layer 21 made of the low-concentration buffer layer 21A and the high-concentration buffer layer 21B may be called "double layer buffer configuration". The "double layer buffer configuration" is the buffer layer with the novel configuration.

In the "double layer buffer configuration," the low-concentration buffer layer 21A with the low dopant concentration is formed on the silicon carbide substrate 10. Thus, the difference between the dopant concentration of the low-concentration buffer layer 21A and the dopant concentration of the silicon carbide substrate 10 is large. Thereby, the difference in the lattice constant is large at the interface between the low-concentration buffer layer 21A and the silicon carbide substrate 10. Consequently, the interface between the low-concentration buffer layer 21A and the silicon carbide substrate 10 is more distorted by the large difference in the lattice constant. Therefore, it is considerable that the efficiency in converting the "BPD" in the silicon carbide substrate 10 into the "TED" that is harmless in the buffer layer 21 is improved. From the above, according to the "double layer buffer configuration," the presence of the low-concentration buffer layer 21A can reduce the "BPD" density in the buffer layer 21.

Additionally, in the "double layer buffer configuration," the high-concentration buffer layer 21B is formed on the low-concentration buffer layer 21A. Thus, the hole-carrier lifetime in the high-concentration buffer layer 21B is shortened, thereby suppressing the degradation in forward current. By the high-concentration buffer layer 21B with the low resistance value, the increase in the resistance value of the buffer layer 21 made of the low-concentration buffer layer 21A and the high-concentration buffer layer 21B can be suppressed. Thereby, the increase in the ON-resistance in the semiconductor device can be suppressed. That is, according to the "double layer buffer configuration," the presence of the high-concentration buffer layer 21B can suppress the degradation in forward current and can reduce the ON-resistance.

Note that the thick low-concentration buffer layer 21A causes risks of the degradation in forward current and the increase in the ON-resistance. Thereby, the high-concentration buffer layer 21B is preferably thicker than the low-concentration buffer layer 21A in order to suppress the degradation in forward current and to reduce the ON-resistance. In other words, the low-concentration buffer layer 21A is preferably thinner than the high-concentration buffer layer 21B.

From the above, since the "double layer buffer configuration" includes the low-concentration buffer layer 21A formed on the silicon carbide substrate 10 and the high-concentration buffer layer 21B formed on the low-concentration buffer layer 21A, both the reduction in the "BPD" density in the buffer layer 21 and the suppression on the degradation in forward current and the suppression on the increase in the ON-resistance which are in the trade-off relationship can be achieved.

### <<Verification Results>>

The verification results showing that the "BPD" density in the buffer layer can be reduced by the "double layer buffer configuration" will be explained below.

As described above, when the thickness of the buffer layer is about 10 µm, the "BPD" density in the buffer layer can be accurately detected by the inspecting method established according to the present embodiment. Accordingly, a "BPD" density in a high-concentration buffer layer is evaluated under use of the following samples. Specifically, the "BPD" density in the high-concentration buffer layer is evaluated based on the inspecting method established according to the present embodiment while changing the dopant concentration and the thickness of the low-concentration buffer layer.

Each of the samples includes the silicon carbide substrate, the low-concentration buffer layer formed on the silicon carbide substrate, and the high-concentration buffer layer formed on the low-concentration buffer layer. The dopant concentration (nitrogen concentration) of the silicon carbide substrate is equal to or more than 5 × 10¹⁸ cm⁻³ and equal to or less than 1 × 10¹⁹ cm⁻³. The dopant concentration (nitrogen concentration) of the low-concentration buffer layer is set to 1 × 10¹⁶ cm⁻³ or 3 × 10¹⁶ cm⁻³. The dopant concentration (nitrogen concentration) of the high-concentration buffer layer is set to 1 × 10¹⁸ cm⁻³. The thickness of the low-concentration buffer layer is changed in a range being equal to or more than 0 and equal to or less than 1.16 µm. As described above, the "BPD" density in the high-concentration buffer layer is evaluated under use of the plurality of samples in each of which the dopant concentration and the thickness of the low-concentration buffer layer are changed.

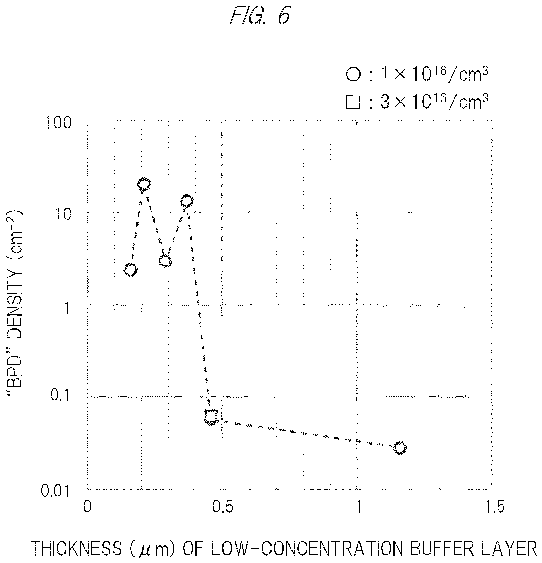

FIG. 6 is a graph illustrating the evaluation results of the "BPD" density in the high-concentration buffer layers.

In FIG. 6, it has been confirmed that the "BPD" density in the high-concentration buffer layer can be reduced in both cases of the dopant concentrations of the low-concentration buffer layer that are 1 × 10¹⁶ cm⁻³ and 3 × 10¹⁶ cm⁻³. Particularly, in both cases of the dopant concentrations of the low-concentration buffer layer that are 1 × 10¹⁶ cm⁻³ and 3 × 10¹⁶ cm⁻³, it has been confirmed that the "BPD" density in the high-concentration buffer layer can be less than 1 cm⁻² when the thickness of the low-concentration buffer layer is equal to or more than 0.46 µm. Further, in both cases of the dopant concentrations of the low-concentration buffer layer that are 1 × 10¹⁶ cm⁻³ and 3 × 10¹⁶ cm⁻³, it has been confirmed that the "BPD" density in the high-concentration buffer layer can be less than 0.1 cm⁻² when the thickness of the low-concentration buffer layer is equal to or more than 0.46 µm. From the above, in order to reduce the "BPD" density in the high-concentration buffer layer, (1) the dopant concentration of the low-concentration buffer layer is preferably equal to or more than 1 × 10¹⁶ cm⁻³ and equal to or less than 3 × 10¹⁶ cm⁻³, and (2) the thickness of the low-concentration buffer layer is preferably equal to or more than 0.46 µm. Thereby, the stack substrate in which the "basal plane dislocation" density in the high-concentration buffer layer is equal to or more than 0 cm⁻² and less than 1 cm⁻² can be achieved. Note that the thick low-concentration buffer layer increases the hole-carrier lifetime, and causes risks of the degradation in forward current and the increase in ON-resistance. Thus, the thickness of the low-concentration buffer layer is preferably equal to or more than 0.46 µm and less than 1 µm.

In the present disclosure, the stack substrate includes the silicon carbide substrate having the first dopant concentration, the low-concentration buffer layer formed on the silicon carbide substrate and having the second dopant concentration lower than the first dopant concentration, the high-concentration buffer layer formed on the low-concentration buffer layer and having the third dopant concentration higher than the second dopant concentration and lower than the first dopant concentration, and the drift layer formed on the high-concentration buffer layer and having the fourth dopant concentration lower than the third dopant concentration.

In the stack substrate according to the present disclosure, the thickness of the low-concentration buffer layer is smaller than the thickness of the high-concentration buffer layer.

In the stack substrate according to the present disclosure, the thickness of the low-concentration buffer layer is equal to or more than 0.46 µm and less than 1 µm.

In the stack substrate according to the present disclosure, the first dopant concentration is equal to or more than 5 × 10¹⁸ cm⁻³ and equal to or less than 1 × 10¹⁹ cm⁻³, the second dopant concentration is equal to or more than 1 × 10¹⁴ cm⁻³, the third dopant concentration is equal to or more than 1 × 10¹⁷ cm⁻³, and the fourth dopant concentration is equal to or more than 1 × 10¹⁵ cm⁻³ and less than 3 × 10¹⁶ cm⁻³.

In the stack substrate according to the present disclosure, the basal plane dislocation density in the high-concentration buffer layer is equal to or more than 0 cm⁻² and less than 1 cm⁻².

In the foregoing, the invention made by the inventors of the present application has been concretely described based on the embodiments. However, it is needless to say that the present invention is not limited to the foregoing embodiments, and various modifications can be made within the scope of the present invention.

## Claims

1. An inspecting method of detecting a crystal defect in a buffer layer by using a first image based on a reflected light caused by irradiation with a light on the buffer layer and a second image based on a photoluminescence light caused by irradiation with an excitation light on the buffer layer,
wherein the buffer layer is made of silicon carbide into which a conductive impurity is introduced,
a wavelength of the excitation light is equal to or less than 386 nm,
a cumulative irradiance of the excitation light is equal to or more than 1.6 W·cm⁻²·sec,
the photoluminescence light is received through a light receiving filter, and
the light receiving filter is a filter transmitting light having a wavelength being equal to or more than the wavelength of the excitation light and equal to or less than 399 nm.

2. The inspecting method according to claim 1,
wherein the cumulative irradiance of the excitation light is equal to or less than 8.7 W·cm⁻²·sec.

3. The inspecting method according to claim 2,
wherein the cumulative irradiance of the excitation light is equal to or less than 2.9 W·cm⁻²·sec.

4. The inspecting method according to claim 1,
wherein the crystal defect is basal plane dislocation.

5. The inspecting method according to claim 1,
wherein a dopant concentration of the buffer layer is equal to or more than 3 × 10¹⁷ cm⁻³ and equal to or less than 1 × 10¹⁹ cm⁻³.

6. The inspecting method according to claim 1,
wherein the conductive impurity is nitrogen.

7. A stack substrate comprising:
a silicon carbide substrate;
a buffer layer formed on the silicon carbide substrate; and
a drift layer formed on the buffer layer,
wherein a basal plane dislocation density in the buffer layer is equal to or more than 0 cm⁻² and less than 5 cm⁻².

8. The stack substrate according to claim 7,
wherein a dopant concentration of the buffer layer is equal to or more than 3 × 10¹⁷ cm⁻³ and equal to or less than 1 × 10¹⁹ cm⁻³.

9. A stack substrate comprising:
a silicon carbide substrate;
a buffer layer formed on the silicon carbide substrate; and
a drift layer formed on the buffer layer,
wherein a basal plane dislocation density in the buffer layer is equal to or more than 0 cm⁻² and less than 5 cm⁻², and
a basal plane dislocation density in the buffer layer is determined by the inspecting method according to claim 1.

10. The stack substrate according to claim 7,
wherein a dopant concentration of the buffer layer is higher than a dopant concentration of the drift layer.

11. The stack substrate according to claim 7,
wherein the stack substrate has a diameter that is equal to or more than 145 mm.

12. A stack substrate comprising:
a silicon carbide substrate having a first dopant concentration;
a low-concentration buffer layer formed on the silicon carbide substrate and having a second dopant concentration lower than the first dopant concentration;
a high-concentration buffer layer formed on the low-concentration buffer layer and having a third dopant concentration higher than the second dopant concentration and lower than the first dopant concentration; and
a drift layer formed on the high-concentration buffer layer and having a fourth dopant concentration lower than the third dopant concentration.

13. The stack substrate according to claim 12,
wherein a thickness of the low-concentration buffer layer is smaller than a thickness of the high-concentration buffer layer.

14. The stack substrate according to claim 13,
wherein the thickness of the low-concentration buffer layer is equal to or more than 0.46 µm and less than 1 µm.

15. The stack substrate according to claim 12,
wherein the first dopant concentration is equal to or more than 5 × 10¹⁸ cm⁻³ and equal to or less than 1 × 10¹⁹ cm⁻³,
the second dopant concentration is equal to or more than 1 × 10¹⁴ cm⁻³,
the third dopant concentration is equal to or more than 1 × 10¹⁷ cm⁻³, and
the fourth dopant concentration is equal to or more than 1 × 10¹⁵ cm⁻³ and less than 3 × 10¹⁶ cm⁻³.

16. The stack substrate according to claim 12,
wherein a basal plane dislocation density in the high-concentration buffer layer is equal to or more than 0 cm⁻² and less than 1 cm⁻².

17. The stack substrate according to claim 12,
wherein the stack substrate has a diameter that is equal to or more than 145 mm.
